Europäisches Patentamt

European Patent Office

Office européen des brevets

(19)

(11) Publication number: **0 439 189 A1**

(12) **EUROPEAN PATENT APPLICATION**

(21) Application number: **91100981.9**

(22) Date of filing: **25.01.91**

(51) Int. Cl.⁵: **G11C 29/00**, G06F 11/26

(30) Priority: **25.01.90 JP 13574/90**

(43) Date of publication of application:
**31.07.91 Bulletin 91/31**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

Applicant: **TOSHIBA MICRO-ELECTRONICS**
**CORPORATION**
**25-1, Ekimaehoncho**
**Kawasaki-ku Kawasaki-shi(JP)**

(72) Inventor: **Hamai, Tsuneo**
**3-10-30 Tsujidoshinmachi**
**Fujisawa-shi, Kanagawa-ken(JP)**

(74) Representative: **Ritter und Edler von Fischern,**
**Bernhard,Dipl.-Ing. et al**
**HOFFMANN - EITLE & PARTNER**
**Arabellastrasse 4**
**W-8000 München 81(DE)**

(54) Device for testing multi-port memory circuits.

(57) A device for testing multi-port memory circuits, comprising a writing port selecting circuit for selecting a writing port from writing ports in a multi-port memory circuit, and outputting a writing data written in the selected writing port, a register for temporarily keeping the writing data outputted from the writing port selecting circuit, and a comparing circuit for comparing the writing data kept in the register with data outputted from all the reading ports in the multi-port memory circuit, judging accordance or discordance between these data, and outputting information on the judgement result.

EP 0 439 189 A1

## DEVICE FOR TESTING MULTI-PORT MEMORY CIRCUITS

BACKGROUND OF THE INVENTION

Field of the Invention

The present invention relates to a device for testing multi-port memory circuits having a plurality of ports, and particularly to a device which can easily carry out tests on all the ports in each circuit.

Description of the Prior Art

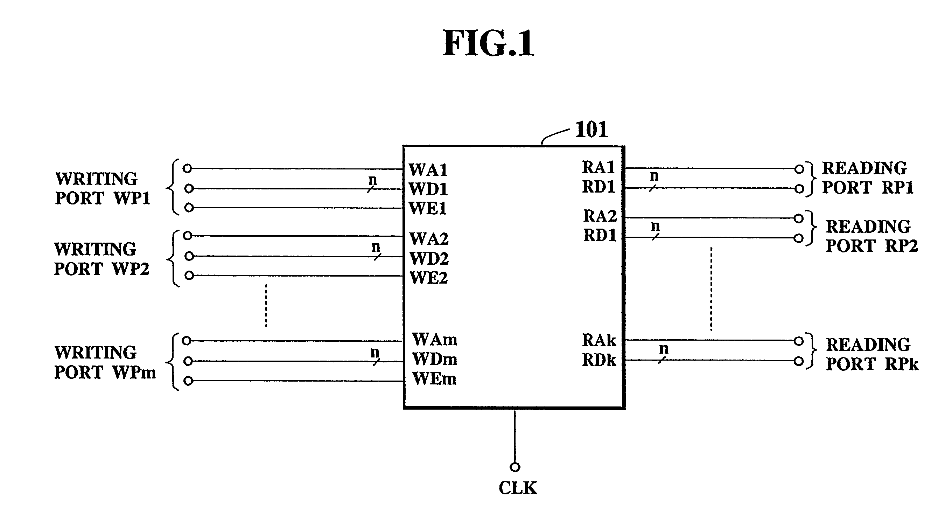

Generally, a multi-port memory circuit 101 has construction as shown in Fig.1. Namely, such a circuit is so provided with a plurality of writing ports WP1 to WPm and a plurality of reading ports RP1 to RPk as to carry out multiple access to one memory cell. Since these ports are operated independently, the writing ports WP1 to WPm respectively have writing control lines WE1 to WEm, writing address lines WA1 to WAm and writing data lines WD1 to WDm, while the reading ports RP1 to RPk respectively have reading address lines RA1 to RAk and reading data lines RD1 to RDk. Moreover, in the multi-port memory circuit 101, for timing control of the writing process, a clock line CLK is also provided.

Such a multi-port memory circuit is advantageous in the multiple access of the memory cell. Namely, the circuit can carry out a plurality of different access to the memory cell at the same time. As examples of such access, the following processes can be mentioned:

Writing data from the writing port WP1 to address 0,
Writing data from the writing port WP2 to address 13,
Reading data from the reading port RP1 to address 2, and
Reading data from the reading port RP2 to address 6.

However, in the procedure of memory test on such a multi-port memory circuit, there have been problems as mentioned below. One of them is that the test cycle required for the test is long, and another is that since there are some ports on which the test is not carried out, the test can not be carried out completely.

Hereinafter, these problems are explained with reference to examples of a system where a general multi-port memory circuit is employed.

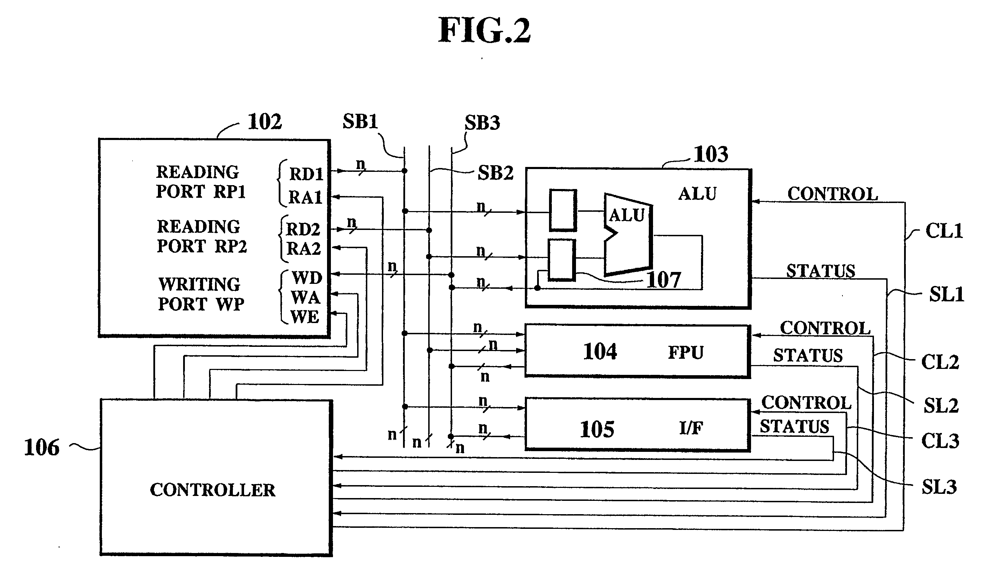

First, the problem on the long test cycle is explained by using an example of a system where a multi-port memory circuit 102 provided with two ports for reading and one port for writing as shown in Fig.2.

In the multi-port memory circuit 102, a reading data line RD1 of a reading port RP1 is connected to a system bus SB1, a reading data line RD2 of a reading port RP2 to a system bus SB2, and a writing data line WD of a writing port WP to a system bus SB3, respectively. Moreover, these system buses SB1 to SB3 are respectively connected to function blocks such as an arithmetic operation unit (ALU) 103, a floating-point operation unit (FPU) 104 and a system interface (I/F) 105. From a controller 106 for controlling the overall operation of the system to the multi-port memory circuit 102, address lines RA1, RA2 for the reading port RP1, RP2, and an address line WA and a writing control line WE for the writing port WP are respectively provided. Besides, to the function blocks ALU 103, FPU 104 and I/F 105, control lines CL1, CL2, CL3 for controlling these function blocks and status lines SL1, SL2 and SL3 for receiving status of these function blocks are respectively connected.

The memory test on the multi-port memory circuit 102 is carried out in the following procedure:

(Step 1)

A writing data is prepared at ALU 103. Then, the writing data is written into a TEMP register 107 in ALU 103. At the same time, the writing data is transferred to the writing data line WD of the port WP in the multi-port memory circuit 102 through the system bus SB3, and stored in a memory cell at a designated address.

(Step 2)

The data written in Step 1 is transferred from the reading data line RD1 of the reading port RP1 of the multi-port memory circuit 102 to ALU 103 through the system bus SB1. Then, the transferred data is compared with the data stored in the TEMP register 107 in ALU 103. Then, the result of comparison is transmitted to the controller 106 through the status line SL1, thereafter judgement of Pass/Fail is carried out in the controller 106.

(Step 3)

The data written in the Step 1 is transferred from the reading data lines RD1, RD2 of the reading ports RP1, RP2 of the multi-port memory circuit 102 to ALU 103 through the system buses SB1, SB2 respectively to compare the data in ALU 103 in the same manner. Then, the comparison result is transmitted to the controller 106 through the status line SL1, thereafter the judgement of Pass/Fail is carried out in the controller 106.

In such a manner, the test on one data to one address is carried out through these three steps. However, since there are two states, that is, 0 level and 1 level, in the data, it is necessary to carry out processes corresponding to six steps in the test to one address. Accordingly, the number of test steps to one address can be generally expressed by the following equation (1):

The number of steps = 2 ×
((The number of writing ports) ×
(1 + The number of reading ports))     (1)

As seen from the equation (1), when the number of ports is increased, the number of steps for the test is also increased, thus the test cycle is elongated.

Next, the problem on existence of ports on which the test can not be carried out is explained.

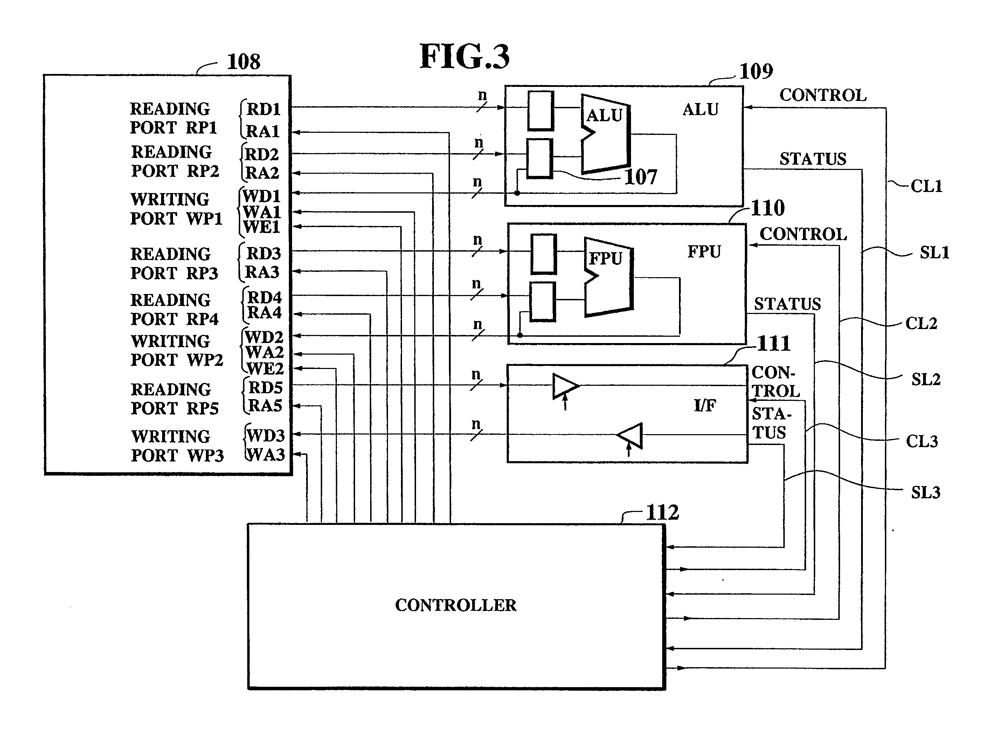

To improve the process capability as compared with that of the system using a multi-port memory circuit shown in Fig.2, there is a known system of a multi-port memory circuit as shown in Fig.3, which can carry out parallel processes.

In the system of a multi-port memory circuit, a multi-port memory 108 is used, in which five reading ports and three writing ports are provided for carrying out multiple access of memory. Besides, function blocks such as ALU 109, FPU 110, I/F 111 and a controller 112 are directly connected to different ports provided in the multi-port memory circuit 108 not through system buses.

In such construction of the system, since FPU 110 and I/F 111 can be operated parallel even when ALU is executed, the process capability over all the system can be improved. Accordingly, this system is now widely used.

Next, the procedure of memory test by using this system is explained.

The testing method of reading ports RP1, RP2 and a writing port WP1 respectively connected to ALU 109 is the same as that for the above-described system shown in Fig.2. Moreover, the test on reading ports RP3, RP4 and a writing port WP2 respectively corresponding to FPU 110 can be also carried out in the same manner as in case of ALU 109.

However, the test on a reading port RP5 and a writing port WP3 respectively connected to I/F 111 can not be carried out in the above-mentioned testing method. The reason is that the circuit of I/F 111 has no comparing circuit so that a writing data written into the writing port WP3 and a reading data from the reading port RP5 of the memory cell can not be compared with each other.

As the result, when the multiple access of ports is carried out by using the characteristics of such a multi-port memory circuit, some ports remain untested.

## SUMMARY OF THE INVENTION

The present invention was made in view of the problems of the prior art, therefore, an object thereof is to provide a device for testing multi-port memory circuits, which can carry out tests on all the ports in a multi-port memory circuit.

The feature of the present invention is a device for testing multi-port memory circuits, which comprises a writing port selecting circuit for selecting a writing port, where a data is written, from a group of writing ports in a multi-port memory circuit, and outputting a writing data written in the selected writing port, a register for temporarily keeping the writing data outputted from the writing port selecting circuit, and a comparing circuit for comparing the writing data kept in the register with data outputted from all the reading ports in the multi-port memory circuit, judging accordance or discordance between these data, and outputting information on the result of judgement.

As another aspect of the present invention, the writing port selecting circuit is so constructed as to be operated in synchronism with a test signal and to output the writing data of the selected writing port only when the test singal is in the active mode.

Moreover, as still another aspect, the comparing circuit is so constructed as to be operated in synchronism with a test signal and to output information of discordance only when the test signal is in the active mode.

In the device for testing multi-port memory circuits of the present invention, the writing port selecting circuit selects one writing port, where a data is written, from writing ports of a multi-port memory circuit, then outputs the writing data of the selected writing port. At the same time, the register temporarily keeps the writing data outputted from the port selecting circuit. Thereafter, the comparing circuit compares the writing data temporarily kept in the register with data outputted from all the reading ports in the multi-port memory circuit, judges accordance or discordance between these data, and outputs information on the result of judgement.

Thus, according to the device for testing multi-port memory circuits, the judgement of accordance or discordance between each writing data from each writing port selected by the writing port selecting circuit corresponding to each memory cell in a multi-port memory circuit and all the data from all the reading ports corresponding to each memory cell can be carried out at the same time.

Moreover, since the writing port selecting circuit is operated in synchronism with a test signal and outputs a writing data of the selected writing port only when the test signal is in the active mode, or since the comparing circuit is operated in synchronism with a test signal and outputs the information on judgement of discordance only when the test signal is in the active mode, the testing device can be operated only when the operation is required.

These and other objects, features and advantages of the present invention will be more apparent from the following description of a preferred embodiment, taken in conjunction with the accompanying drawings.

BRIEF DESCRIPTION OF THE DRAWINGS

Fig.1 is a block diagram to show construction of a general multi-port memory circuit;
Fig.2 is a block diagram to show a conventional multi-port memory circuit system;
Fig.3 is a block diagram to show another conventional multi-port memory circuit system;
Fig.4 is a block diagram to show an embodiment of a device for testing a multi-port memory circuit according to the present invention;
Fig.5 is a block diagram to show a detailed construction of a writing port selecting circuit used in the embodiment shown in Fig.4;
Fig.6 is a block diagram to show a detailed construction of a register used in the embodiment shown in Fig.4;
Fig.7 is a block diagram to show another circuit construction of the register shown in Fig.4;
Fig.8 is a block diagram to show a detailed construction of a comparing circuit used in the embodiment shown in Fig.4; and
Fig.9 is a circuit block diagram of another embodiment of the present invention.

DETAILED DESCRIPTION OF THE EMBODIMENTS

Hereinafter, an embodiment of the present invention will be explained in detail with reference to the drawings.

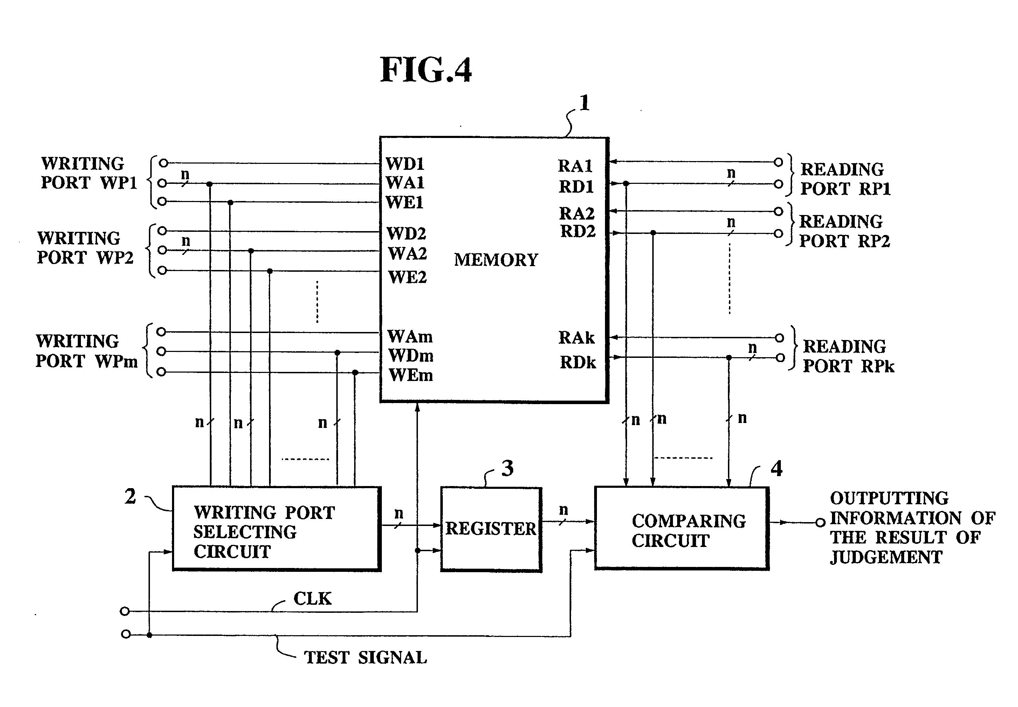

Fig.4 shows a system construction of the embodiment of the present invention. As is similar to that shown in Fig.1, a multi-port memory circuit 1 used in this embodiment comprises m writing ports WP1 to WPm and k reading ports RP1 to RPk, and the bit width of data to be dealt with in the system is n. Incidentally, since the construction of address lines, data lines and control lines respectively corresponding to the writing ports WP1 to WPm and reading ports RP1 to RPk is the same as that shown in Fig.1, the explanation is omitted here.

In the embodiment, a writing port selecting circuit 2 for selecting one writing port WPi, where a data is to be written, from the writing ports WP1 to WPm, and outputting to a register a writing data which is the same as the data inputted to the selected writing port WPi, a register 3 for temporarily keeping the writing data outputted from the writing port selecting circuit 2, and a comparing circuit 4 for comparing the writing data kept in the register 3 with all the data from respective reading ports RP1 to RPk, judging accordance or discordance between these data, and outputting information of the result of judgement are respectively connected to the multi-port memory circuit 1.

To the writing port selecting circuit 2, writing control lines WE1 to WEm and writing data lines WD1 to WDm corresponding to the respective writing port WP1 to WPm are connected, further a test signal TEST is inputted, so that a writing data corresponding to a writing port WPi selected through any suitable writing control line WEi is outputted to the register 3 only when the test signal TEST is in the active mode.

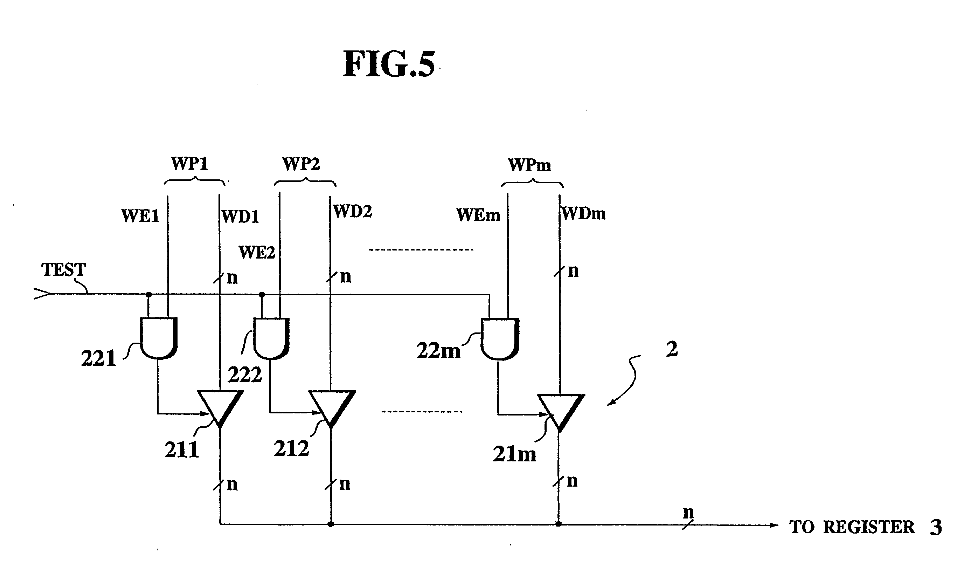

The writing port selecting circuit 2 can be constructed with a circuit as shown in Fig.5. In the circuit construction in Fig.5, the writing data lines WD1 to WDm connected to respective writing ports WP1 to WPm are respectively connected to tri-state buffers 211 to 21m, further respective outputs of the tri-state buffers 211 to 21m serve as output lines of the writing port selecting circuit 2. Moreover, respective writing control lines WE1 to WEm and a test signal line TEST are connected to respective inputs of AND circuits 221 to 22m, and respective outputs of the AND circuits 221 to 22m are connected to the tri-state buffers 211 to 21m so as to give control signals to the buffers respectively.

In such construction, when the test signal TEST is active, and a suitable writing control line WEi of the writing control lines WE1 to WEm is also in the active state, the output of an AND circuit 22i is the level of 1, so that a tri-state buffer 21i becomes ON. As the result, a writing data of the corresponding writing port WPi is selected, then outputted by the writing port selecting circuit 2. However, when the writing control line WEi is not active, the output of the AND circuit 22i is the level of 0, so that the tri-state buffer 21i becomes OFF. As the result, the writing data of the writing port WPi is neither selected nor outputted from the writing port selecting circuit 2 to the register 3. Ordinarily, since the writing process is carried out from only one of the writing port WP1 to WPm, at any given time, there is only one writing control line in the active state. Accordingly, only one writing data is selected and outputted to the register 3.

While, the register 3 is composed of a logic circuit comprising flip-flops, and is so constructed as to store a data outputted from the writing port selecting circuit 2 at the same timing as in the multi-port memory circuit 1 and to temporarily keep the data.

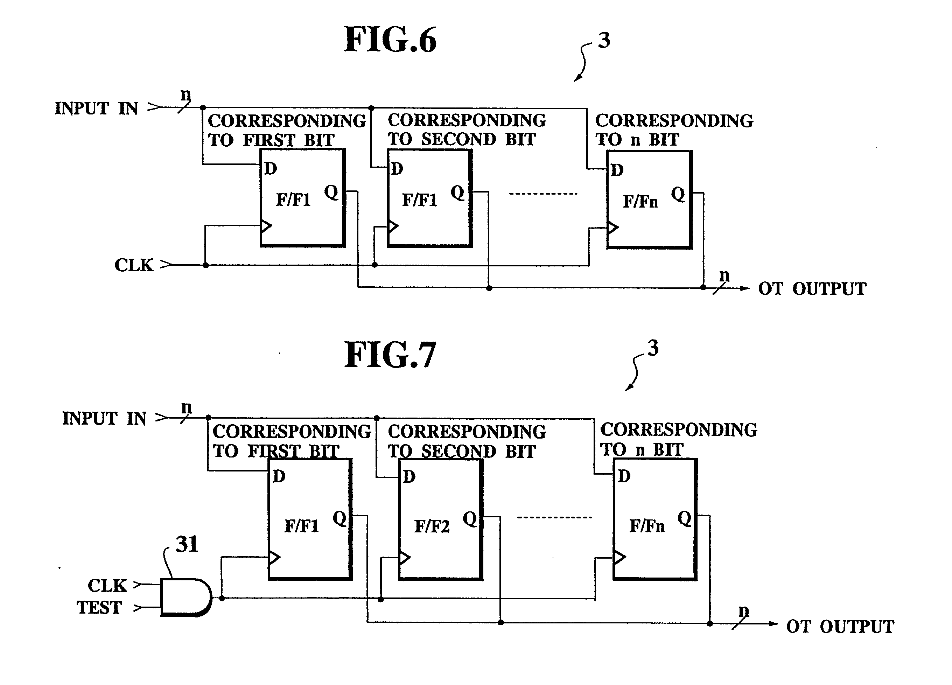

The register 3 can be constructed with a circuit as shown in Fig.6. In the circuit, n flip-flops F/F1 to F/Fn corresponding to each bit of data comprising n bits are connected to a data input line IN from the writing port selecting circuit 2, and a clock from a clock line CLK is inputted to respective filp-flops F/F1 to F/Fn at the same time. Moreover, an output line OT from each of the flip-flops F/F1 to F/Fn is connected to the comparing circuit 4.

By such construction, in accordance with a clock signal from the clock line CLK, the register 3 can keep a data outputted from the writing port selecting circuit 2 at the same time as a timing when a data is received by the writing port WPi selected by the writing port selecting circuit 2.

Fig.7 shows another circuit construction of the register 3, in which the construction of the flip-flops F/F1 to F/Fn is the same as in the circuit in Fig.6. However, in the circuit in Fig.7, since an AND circuit 31 is added, it becomes possible that the test signal TEST is inputted together with the clock signal of the clock line CLK, and the data received in the writing port selecting circuit 2 can be stored in the register 3 only when the test signal TEST is in the active state.

Moreover, the comparing circuit 4 compares the writing data corresponding to the specifically selected writing port WPi and kept in the register 3 with data outputted from the reading ports RP1 to RPk, and generates information on accordance or discordance between these data from the result of comparison, then outputs the information of discordance only when the test signal TEST is in the active state.

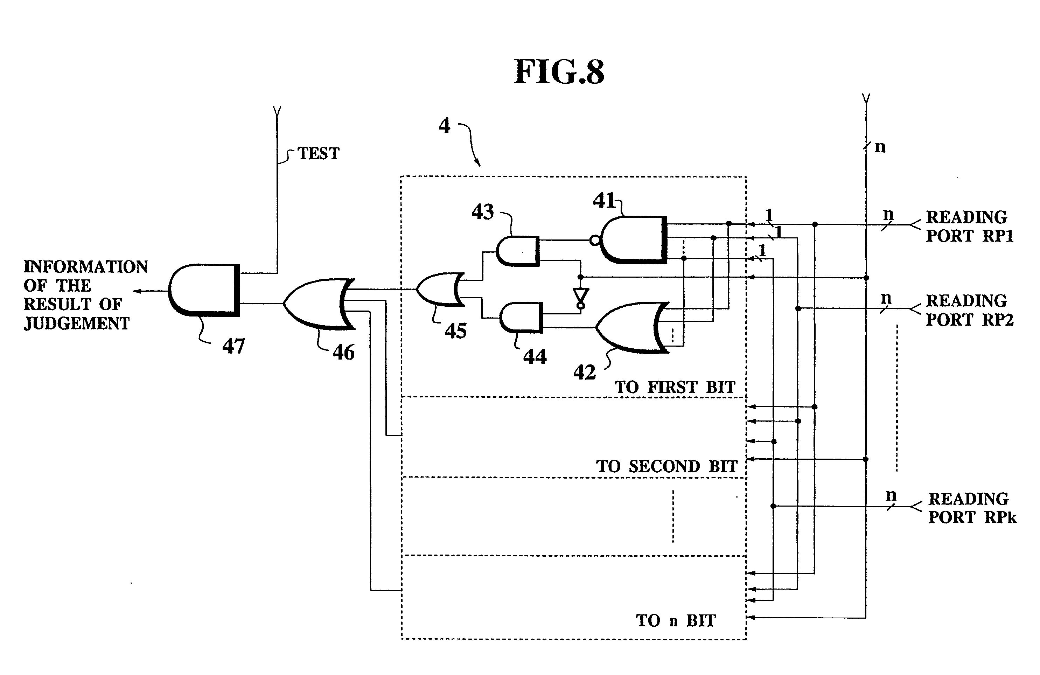

The comparing circuit 4 can be constructed with a circuit as shown in Fig.8. In the comparing circuit 4 shown in Fig.8, all the data from the reading ports RP1 to RPk are respectively inputted to NAND circuits 41 and OR circuits 42 corresponding to respective bits. Moreover, the output of each NAND circuit 41 is inputted to each AND circuit 43 together with a data of the same bit of the register 3, while the output of each OR circuit 42 is inputted to each AND circuit 44 together with an inverted data to a data of the same bit in the register 3.

Furthermore, the output of each pair of AND circuits 43, 44 is inputted to each OR circuit 45, and the output of each OR circuit is outputted as information concerning accordance or discordance corresponding to any given bit number.

Then, the output of each OR circuit 45 corresponding to each bit is inputted to an OR circuit 46. Further the OR circuit 46 outputs information on accordance or discordance over all the n bits so as to unify each information to each bit, thereafter AND information is made by an AND circuit 47 with the unified information from the circuit 46 and the test signal TEST. Moreover, the information of discordance is outputted only when the test signal TEST is in the active state.

Incidentally, by the AND circuit 47, when the test signal TEST is not active, the information of accordance is always outputted irrespectively of the output of the OR circuit 46.

Next, operation for one bit of the comparing circuit 4 is described in detail.

First, a case where a data of the level 1 is kept in the register 3 is considered.

Moreover, when all the data read out from respective reading ports RP1 to RPk are at the level of 1, each NAND circuits 41 outputs a data of the level 0, and each AND circuit 43 also outputs a data of the level 0. While, each OR circuit 42 outputs a data of the level 1. However, since an inverted data of the level 0 corresponding to the data of 1 from the register 3 is inputted to each AND circuit 44, the output is at the level of 0, so that the level of output from each OR circuit 45 also becomes 0. Accordingly, the information of judgement on accordance or discordance for the corresponding one bit becomes "accordance", so that the data of the level 0 expressing "accordance" is inputted to each OR circuit 46.

However, when some of the data from the reading ports RP1 to RPk are at the level 0, the level of output from each NAND circuit 41 becomes 1, and that from each AND circuit 43 also becomes 1. As the result, each OR circuit 45 outputs a data of the level 1 for expressing that the data for one bit is "discordance", then the data is inputted to the OR circuit 46 to unify data corresponding to all the bits.

Next, another case where a data of the level 0 is kept in the register 3 is considered.

Moreover, when all the data read from the reading ports RP1 to RPk are at the level of 0, each NAND circuit 41 outputs a data of the level 1. However, since a data of the level 0 is inputted to each AND circuit 43 from the register 3, the level of output also becomes 0. While, the output of each OR circuit 42 is at the level 0, the level of output from each AND circuit 44 becomes 0, so that each OR circuit 45 also outputs a data of the level 0. As the result, the data of the level 0 for expressing "accordance" is outputted for the corresponding one bit.

However, when some of the data from the reading ports RP1 to RPk are at the level of 1, the level of output from each NAND circuit 41 becomes 1, while that from each AND circuit 43 becomes 0 since the level of input from the register 3 is 0. Moreover, since the level of some data from the reading ports RP1 to RPk is 1, each OR circuit 42 outputs a data of the level 1 to each AND circuit 44. Furthermore, since the level of another input to each AND circuit 44 is 1 which is corresponding to the inverted data to the data from the register 3, the level of output from the AND circuit 44 becomes 1. As the result, each OR circuit 45 outputs a data of the level 1 for showing "discordance" for the corresponding one bit.

The operative modes based on the above combinations of data are respectively shown in Table 1 on this page.

## Table 1

### Judgement Result from Comparing Circuit 4 for One Bit

|  | Case 1 | Case 2 | Case 3 | Case 4 |
|---|---|---|---|---|
| Output from AND Circuit 41 | 0 | 1 | 1 | 1 |
| Output from AND Circuit 43 | 0 | 1 | 0 | 0 |
| Output from OR Circuit 42 | 1 | 1 | 0 | 1 |
| Output from AND Circuit 44 | 0 | 0 | 0 | 1 |
| Output from OR Circuit 45 | 0 | 1 | 0 | 1 |

(Note)

|  | Data of Register 3 | Data of Reading Ports |
|---|---|---|
| Case 1 | 1 | All 1 |
| Case 2 | 1 | 0 is included |
| Case 3 | 0 | All 0 |
| Case 4 | 0 | 1 is included |

In such a manner, the information of judgement on accordance or discordance produced for each bit is inputted to the OR circuit 46 for making the unified judgement on accordance or discordance over all the bits. On the other hand, when the data over all the bits are 0, the OR circuit 46 outputs the data of 0, the information on judgement of accordance, to the AND circuit 47. In the other cases, that is, when some of the data are 1, the circuit 46 outputs 1 which is the information on discordace.

Then, the AND circuit 47 outputs the data of 1 or information on judgement of discordance only when the test signal TEST is in the active state. In the other cases, the circuit 47 outputs 0 or information on accordance irrespectively of the output from the OR circuit 46.

Thus, according to this embodiment, the writing data from each writing port WPi selected by the writing port selecting circuit 2 from the writing ports WP1 to WPm in the multi-port memory circuit 1 is temporarily kept in the register 3, thereafter the comparing circuit 4 compares the writing data kept in the register 3 with all the data from respective reading ports RP1 to RPk at the same time, judges accordance or discordance in the comparison, and outputs the information on discordance only when the test signal TEST is in the active state.

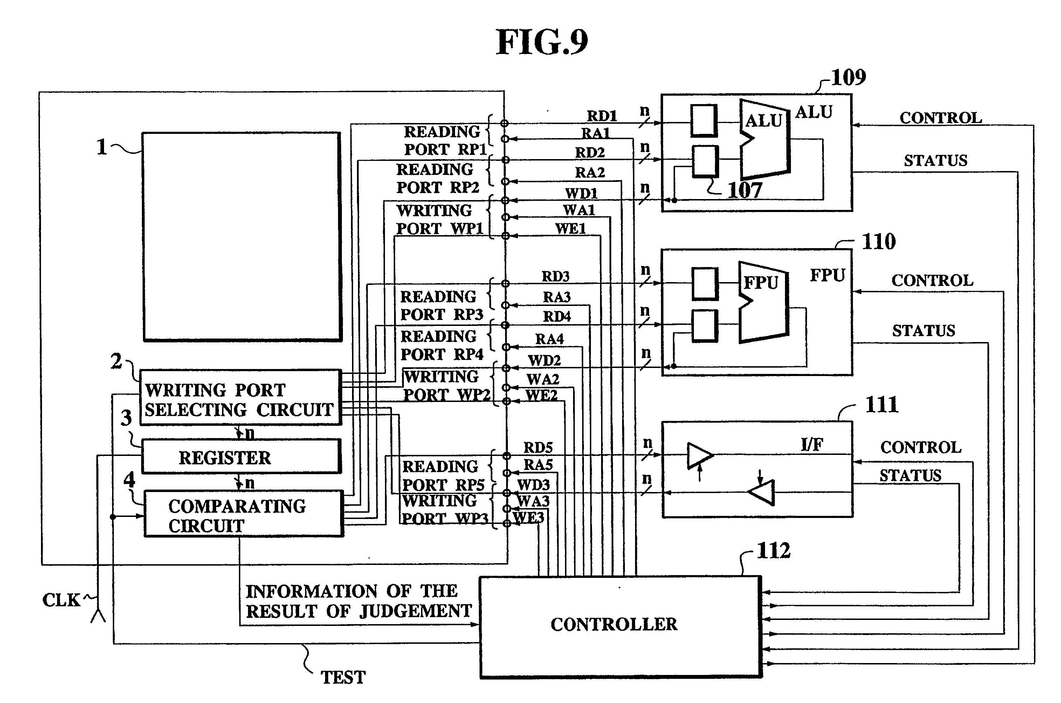

Fig.9 shows another embodiment of a device for testing multi-port memory circuits related to the present invention, comprising five reading ports and three writing ports as in the conventional test device shown in Fig.3. Incidentally, in the multi-port memory circuit 1 in Fig.9, the same parts as those shown in Fig.3 are respectively designated by the same reference numerals or characters.

In this embodiment, writing data lines WD1 to WD3 and writing control lines WE1 to WE3 are provided so as to respectively input data to a writing port selecting circuit 2 from writing ports WP1 to WP3 and to input a test signal TEST from a controller 112.

Moreover, a clock line CLK is connected to a register 3 to input a clock signal thereto, while to a comparing circuit 4, reading data lines RD1 to RD5 are connected so as to respectively input data from reading ports RP1 to RP5.

Furthermore, the comparing circuit 4 is connected to the controller 112 to input information of judgement on accordance or discordance thereto.

By the test device of this embodiment, the multi-port memory circuit 1 is tested in the following procedure:

(Step 1)

The test signal TEST is set in the active state, then a writing data of a suitable writing port, for example writing port WP1, is kept in the register 3 through the writing port selecting circuit 2.

(Step 2)

In the active state of the test signal TEST, data on address are read out from all the reading ports RP1 to RP5, then accordance or discordance between these data and the data written in Step 1 is judged in the comparing circuit 4 at the same time. Thereafter, information on the judgement result of accordance or discordance is outputted to the controller 112, then Pass/Fail is judged.

The test comprising the above two steps is carried out on both of the writing data 0 and 1. Accordingly, the test for one address can be completed by four steps irrespectively of the number of reading ports.

In the conventional procedure steps for testing the multi-port memory circuit 108 shown in Fig.3, the number of steps should be decided by the equation (1):

$ST1 = 2 \times 3 \times (1 + 5) = 36$ (steps)

While, in this embodiment, the number of steps is determined as twice the number of writing ports, so that it (ST2) can be calculated as follows:

$ST2 = 2 \times 2 \times 3 = 12$ (steps)

Accordingly, by this embodiment, the number of test steps can be far reduced, and so is the test cycle.

In summary, according to the present invention, since the judgement on accordance or discordance between the writing data of each writing port and all the data over the reading ports is carried out at the same time, the number of steps for the memory test on the multi-port memory circuit can be decided only by the number of writing ports, so that it (ST) can be expressed by the following equation:

$ST = 2 \times 2 \times$ (the number of writing ports)

Accordingly, the ratio between the number of memory steps of this embodiment and that of the conventional test device becomes 2/(the number of reading ports), so that both of the number of test steps and the test cycle can be much reduced.

Moreover, since all the reading data of the reading ports are compared with each writing data at the same time, no port remains untested, and all the port can be tested correctly.

Various modifications will become possible for those skilled in the art after receiving the teachings of the present disclosure without departing from the scope thereof.

7

**Claims**

1. A device for testing multi-port memory circuits, comprising:
   (a) writing port selecting means for selecting a writing port from a group of writing ports of a multi-port memory circuit, and outputting a writing data of the selected writing port;
   (b) keeping means for temporarily keeping the writing data outputted from the writing port selecting means; and
   (c) comparing means for comparing the writing data kept in the keeping means with data outputted from all the reading ports in the multi-port memory circuit, judging accordance or discordance between these data, and outputting information on the result of judgement.

2. The device for testing multi-port memory circuits according to claim 1, wherein the writing port selecting means is so constructed as to be operated in synchronism with a test signal and to output the writing data of the selected writing port only when the test singal is in the active mode.

3. The device for testing multi-port memory circuits according to claim 1, wherein the comparing means is so constructed as to be operated in synchronism with a test signal and to output the information of discordance only when the test signal is in the active mode.

# FIG.1

# FIG.2

EP 0 439 189 A1

# FIG.3

EP 0 439 189 A1

# FIG.4

WRITING PORT WP1 {  WD1, WA1, WE1 } — n

WRITING PORT WP2 {  WD2, WA2, WE2 } — n

WRITING PORT WPm {  WAm, WDm, WEm }

MEMORY — 1

RA1, RD1 — n — } READING PORT RP1

RA2, RD2 — n — } READING PORT RP2

RAk, RDk — n — } READING PORT RPk

2 — WRITING PORT SELECTING CIRCUIT — n — 3 REGISTER — n — 4 COMPARING CIRCUIT — OUTPUTTING INFORMATION OF THE RESULT OF JUDGEMENT

CLK

TEST SIGNAL

EP 0 439 189 A1

# FIG.5

EP 0 439 189 A1

# FIG.6

INPUT IN ⊳ /n

CORRESPONDING TO FIRST BIT

CORRESPONDING TO SECOND BIT

CORRESPONDING TO n BIT

D  F/F1  Q

D  F/F1  Q

------------

D  F/Fn  Q

CLK ⊳

/n ⟶ OT OUTPUT

# FIG.7

INPUT IN ⊳ /n

CORRESPONDING TO FIRST BIT

CORRESPONDING TO SECOND BIT

CORRESPONDING TO n BIT

D  F/F1  Q

D  F/F2  Q

-------------

D  F/Fn  Q

31

CLK ⊳
TEST ⊳

/n ⟶ OT OUTPUT

EP 0 439 189 A1

# FIG.8

TEST

INFORMATION
OF THE
RESULT OF
JUDGEMENT

47

46

45

43

44

42

41

4

n

n — READING PORT RP1

1

1

1

n — READING PORT RP2

TO FIRST BIT

TO SECOND BIT

n — READING PORT RPk

TO n BIT

EP 0 439 189 A1

# FIG.9

EP 0 439 189 A1

**European Patent Office**

**EUROPEAN SEARCH REPORT**

Application Number

**EP 91 10 0981**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN vol. 12, no. 350 (P-760), 20 September 1988; & JP - A - 63103984 (FUJITSU LTD.) 09.05.1988 — — — | 1-3 | G 11 C 29/00 G 06 F 11/26 |
| A | PATENT ABSTRACTS OF JAPAN vol. 11, no. 144 (P-574), 12 May 1987; & JP - A - 61280099 (MEIDENSHA ELECTRIC MFG. CO. LTD.) 10.12.1986 — — — — — | 1-3 | |

| | |
|---|---|
| | **TECHNICAL FIELDS SEARCHED (Int. Cl.5)** |
| | G 11 C<br>G 06 F |

The present search report has been drawn up for all claims

| Place of search | Date of completion of search | Examiner |
|---|---|---|
| Berlin | 30 April 91 | ABRAM R |